# FASCICULE DE BREVET EUROPEEN

(11) **EP 2 080 734 B1**
(45) Date de publication et mention de la délivrance du brevet: **02.03.2011**
(21) Numéro de dépôt: 09150388.8
(22) Date de dépôt: 12.01.2009
(51) Int. Cl.: B81C 1/00, H01L 21/768, H01L 23/532

(54) **Procédé de réalisation de cavités d'air dans des microstructures**
Herstellungsverfahren von Lufthohlräumen in Mikrostrukturen
Method for manufacturing air cavities in microstructures

(30) Priorité: 16.01.2008 FR 0850249
(43) Date de publication de la demande: 22.07.2009
(73) Titulaire: Commissariat à l'Énergie Atomique et aux Énergies Alternatives, 75015 Paris (FR)
(72) Inventeur: Jousseaume, Vincent, 38700, LE SAPPEY EN CHARTREUSE (FR); Zenasni, Aziz, 38610, GIERES (FR)
(74) Mandataire: Ilgart, Jean-Christophe

(56) Documents cités:
- EP-A- 1 739 737
- DE-A1- 10 355 395
- US-A1- 2002 022 378
- US-B1- 6 387 818

## Description

### DOMAINE TECHNIQUE

La présente invention se rapporte à un procédé permettant de réaliser des cavités d'air dans des microstructures.

Dans ce qui précède et ce qui suit, on utilise l'expression « cavité d'air » comme équivalent français de l'expression anglaise « air gap », laquelle est utilisée dans la littérature anglo-saxonne pour désigner une cavité qui peut être remplie d'air, d'un gaz autre que l'air et, en particulier, d'un gaz neutre tel que l'argon, ou bien encore de vide.

La présente invention est notamment susceptible d'être utilisée dans la fabrication de structures d'interconnexions à cavités d'air pour circuit intégré. Toutefois, elle peut également être utile pour réaliser d'autres types de microstructures à cavités d'air comme, par exemple, des microsystèmes électromécaniques (ou MEMS) à cavités résonantes du type BAW (« Bulk Acoustic Wave »), ou encore des micro-batteries.

### ÉTAT DE LA TECHNIQUE ANTERIEURE

La fabrication de dispositifs en microélectronique ou en microtechnologie nécessite, dans les solutions les plus avancées, la réalisation de cavités d'air.

Pour réaliser ces cavités d'air, l'une des approches actuelles consiste à dégrader un matériau sacrificiel, typiquement de l'oxyde de silicium, au moyen d'un agent d'attaque chimique, par exemple de l'acide fluorhydrique, qui doit traverser une membrane pour atteindre ce matériau.

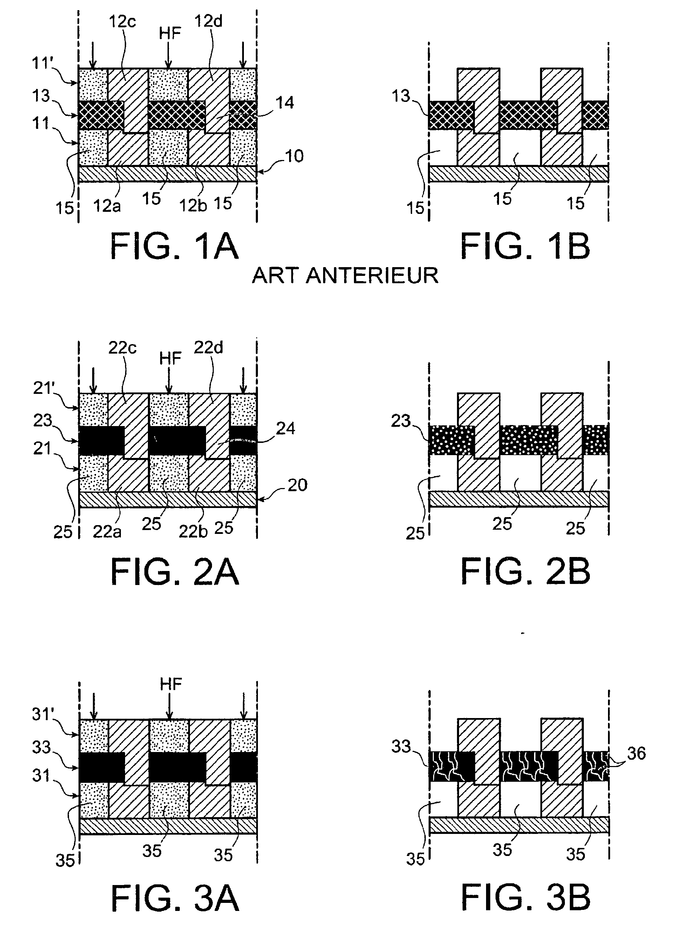

Un exemple de réalisation de cavités d'air selon cette approche, dans le cas d'une structure à deux niveaux d'interconnexions pour circuit intégré, est illustré de façon schématique sur les figures 1A et 1B.

Comme visible sur la figure 1A qui montre la structure avant que les cavités d'air ne soient formées, celle-ci comprend :
* un substrat 10,
* une première couche 11 d'un matériau sacrificiel qui recouvre ce substrat et dans laquelle sont noyées des lignes métalliques 12a et 12b, typiquement en cuivre,
* une membrane perméable 13 qui recouvre la couche 11 et les lignes métalliques 12a et 12b et qui délimite avec le substrat 10 et lesdites lignes métalliques des cavités 15 remplies de matériau sacrificiel, et
* une deuxième couche 11' de matériau sacrificiel qui recouvre la membrane perméable 13 et dans laquelle sont noyées des lignes métalliques 12c et 12d, lesquelles sont connectées respectivement aux lignes métalliques 12a et 12b par l'intermédiaire de traverses métalliques 14 s'étendant dans toute l'épaisseur de la membrane 13.

La mise en contact (symbolisée par les flèches noires sur la figure 1A) de la structure avec un agent capable de dégrader le matériau sacrificiel provoque la dégradation de la deuxième couche 11' de matériau sacrificiel puis, suite à la diffusion de l'agent d'attaque au travers de la membrane perméable 13, celle de la première couche 11 de matériau sacrificiel. Il suffit alors d'éliminer l'agent d'attaque chimique de la structure (avec tous les résidus de dégradation qu'il contient), par exemple avec du dioxyde de carbone supercritique, pour que les cavités 15 initialement remplies de matériau sacrificiel deviennent des cavités d'air, comme illustré sur la figure 1B.

Outre d'être capable de laisser passer l'agent d'attaque chimique, la membrane doit répondre à un cahier des charges très précis, à savoir :
■ résister elle-même à l'agent d'attaque chimique,
■ être compatible avec les différents procédés et traitements mis en oeuvre pour réaliser la structure dans laquelle elle est intégrée (métallisations, polissages mécano-chimiques, recuits thermiques, ......) et, en particulier, être stable à des températures pouvant atteindre 400°C,
■ avoir de bonnes propriétés mécaniques puisqu'elle participe à l'ossature de la structure, et
■ présenter une constante diélectrique faible, c'est-à-dire au plus égale à 4,0, dans le cas d'une structure d'interconnexions pour circuit intégré.

Les membranes perméables actuellement utilisées sont généralement des membranes en polymères.

Or, l'intégration de telles membranes dans des microstructures et, notamment, dans des structures d'interconnexions à cavités d'air pour circuit intégré, n'est pas sans poser un certain nombre de problèmes.

En effet, de par leur perméabilité, ces membranes peuvent être infiltrées par les différents produits chimiques qui sont employés au cours de la fabrication des microstructures et, en particulier, lors des opérations de gravure, de « stripping », de nettoyage et de dépôt des métaux nécessaires à la réalisation des lignes métalliques, ce qui tend à fragiliser ces membranes et les expose à un sérieux risque de dégradation.

De plus, le fait que ces membranes de type polymères sont peu résistantes mécaniquement pose également des problèmes lors de la mise en oeuvre d'opérations abrasives telles que des polissages mécano-chimiques.

DE 103 55 395 décrit un procédé permettant de réaliser une cavité dans une couche en silicium, qui consiste à former ou à déposer sur cette couche un masque de gravure muni d'ouvertures traversantes, puis à injecter dans ces ouvertures un gaz de gravure sous pression, du type CIF₃. Dans une variante de mise en oeuvre de ce procédé, le masque de gravure est recouvert d'une couche organique ou inorganique, qui est elle-même munie de pores traversants de diamètre moyen inférieur à celui des ouvertures du masque, auquel cas l'injection du gaz de gravure est réalisée dans les pores de cette couche poreuse.

### EXPOSÉ DE L'INVENTION

L'invention permet justement de résoudre les problèmes mentionnés ci-dessus puisqu'elle propose un procédé pour réaliser au moins une cavité d'air dans une microstructure, du type comprenant la dégradation d'un matériau sacrificiel par diffusion d'un agent d'attaque chimique au travers d'une membrane, qui comprend :
a) la fourniture d'une microstructure comprenant au moins une cavité remplie d'un matériau sacrificiel, cette cavité étant limitée sur au moins une partie de sa surface par une membrane imperméable mais qui peut être rendue perméable sous l'action d'un agent d'attaque chimique capable de dégrader le matériau sacrificiel ;
b) la mise en contact de la microstructure avec ledit agent d'attaque chimique pour rendre la membrane perméable et dégrader le matériau sacrificiel ; et
c) l'élimination de l'agent d'attaque chimique de la microstructure, moyennant quoi on obtient une cavité d'air ; et
dans lequel l'agent d'attaque chimique est un fluide contenant de l'acide fluorhydrique ou du fluorure d'ammonium, éventuellement en mélange avec de l'acide fluorhydrique.

Ainsi, selon l'invention, la membrane qui est intégrée dans la microstructure est une membrane qui est imperméable mais que l'on peut rendre ultérieurement perméable en la soumettant à l'action d'un agent d'attaque chimique qui est également capable d'agir sur le matériau sacrificiel pour le dégrader.

Il suffit donc de mettre la microstructure en contact avec l'agent d'attaque chimique pour obtenir à la fois la transformation de la membrane imperméable en une membrane perméable, la diffusion de cet agent au travers de cette membrane et la dégradation du matériau sacrificiel, puis d'éliminer ledit agent d'attaque chimique de la microstructure pour obtenir une cavité d'air.

Selon un premier mode de mise en oeuvre préféré du procédé de l'invention, la membrane imperméable est constituée d'un seul matériau, auquel cas ce matériau comprend, de préférence, du silicium, du carbone, de l'hydrogène, de l'oxygène et, éventuellement, de l'azote et/ou du fluor, avec une majorité de liaisons silicium-carbone et une proportion de liaisons silicium-oxygène telle que l'oxygène présent dans ledit matériau représente au plus 30% en nombre d'atomes.

En effet, une telle membrane peut être rendue perméable sous l'action d'un agent d'attaque chimique capable de détruire sélectivement les liaisons silicium-oxygène qu'elle renferme (c'est-à-dire sans toucher aux autres liaisons et, en particulier, aux liaisons silicium-carbone, silicium-hydrogène et carbone-hydrogène) et, partant, de lui conférer une porosité ouverte sur la totalité de son épaisseur, ce qui est notamment le cas d'une solution aqueuse d'acide fluorhydrique.

Dans ce qui précède et ce qui suit, on considère qu'un matériau comprend une majorité de liaisons silicium-carbone lorsque plus de 50% des liaisons faites par les atomes de silicium présents dans ce matériau sont des liaisons silicium-carbone.

Conformément à l'invention, le matériau comprenant du silicium, du carbone, de l'hydrogène, de l'oxygène et, éventuellement, de l'azote et/ou du fluor est, de préférence, de type SiᵥC_{w}H_{y}O_{z} ou SiᵥC_{w}NₓH_{y}O_{z} avec v, w, x, y et z tous différents de 0.

Des membranes constituées d'un matériau de ce type peuvent être formées notamment par la technique de dépôt chimique en phase vapeur assisté par plasma, plus connue sous le sigle PECVD pour « **P**lasma **E**nhanced **C**hemical **V**apor **D**éposition ».

Pour obtenir une membrane de type SiᵥO_{w}H_{y}O_{z}, on utilise alors, de préférence, un plasma contenant un premier précurseur organosilicié exempt d'oxygène et un deuxième précurseur constitué d'oxygène, seul ou en combinaison avec du carbone et/ou de l'hydrogène, tandis que, pour obtenir une membrane de type SiᵥC_{w}NₓH_{y}O_{z}, on préfère ajouter à ce plasma un troisième précurseur constitué d'azote, seul ou en combinaison avec de l'hydrogène et/ou du carbone.

A titre d'exemple, le premier précurseur peut être un alkylsilane tel que le diméthylsilane, le triméthylsilane ou encore le tétraméthylsilane ; le deuxième précurseur peut être de l'oxygène ou du dioxyde de carbone, tandis que le troisième précurseur peut être de l'azote ou de l'ammoniac.

Dans tous les cas, les proportions des différents précurseurs dans le plasma sont convenablement choisies pour que la concentration atomique de l'oxygène soit inférieure à 30% dans la membrane.

En variante, il est également possible d'obtenir une membrane de type SiᵥC_{w}H_{y}O_{z} avec un plasma ne contenant qu'un seul précurseur constitué à la fois de silicium, de carbone, d'hydrogène et d'oxygène mais ayant une teneur en oxygène inférieure ou égale à 30% atomique comme, par exemple, le diéthoxyméthylsilane ou l'octaméthylcyclotétrasiloxane. De manière similaire, il est possible d'obtenir une membrane de type SiᵥC_{w}NₓH_{y}O_{z} en utilisant ce précurseur conjointement avec un autre précurseur constitué d'azote, seul ou en combinaison avec de l'hydrogène et/ou du carbone.

Conformément à l'invention, le plasma peut, en outre, contenir un ou plusieurs gaz vecteurs inertes, en particulier de l'hélium et/ou de l'argon.

La formation de la membrane imperméable par PECVD peut notamment être réalisée dans un réacteur à couplage capacitif. Les paramètres opératoires sont alors, de préférence, les suivants : une excitation de type radiofréquence à 13,56 MHz ; une puissance comprise entre 100 et 900 W, une température comprise entre 100 et 450°C, pour une pression comprise entre 1 et 10 torrs (0,133 à 1,33 kPa) et des débits de précurseurs compris entre 1 et 10000 cm³/minute.

Au terme de cette opération, les caractéristiques de la membrane et, notamment, sa concentration atomique en oxygène peuvent être vérifiées par des méthodes d'analyse de composition telles que la spectroscopie infrarouge en transmission.

Selon un autre mode de mise en oeuvre préféré du procédé de l'invention, la membrane imperméable est constituée d'une matrice comprenant au moins un premier matériau résistant à l'agent d'attaque chimique et dans laquelle est dispersé au moins un deuxième matériau dégradable par ledit agent d'attaque chimique.

Dans ce cas, le premier matériau est, de préférence, un matériau qui comprend du silicium, du carbone, de l'hydrogène et, éventuellement, de l'azote et/ou du fluor, mais qui est exempt d'oxygène.

Mieux encore, le premier matériau est de type SiᵥC_{w}H_{y} avec v, w et y tous différents de 0, dont l'obtention sous une forme dense, notamment par PECVD à partir de couples de précurseurs du type triméthylsilane/hélium ou silane/méthane, est aujourd'hui parfaitement maîtrisée.

Quant au deuxième matériau, il s'agit, de préférence, d'oxyde de silicium qui est l'un des matériaux sacrificiels les plus utilisés en microélectronique.

Conformément à l'invention, on préfère que cet oxyde de silicium soit présent dans la matrice sous la forme de nanofils traversants, c'est-à-dire de nanofils qui s'étendent d'une surface à l'autre de cette matrice, et dont la dégradation par l'agent d'attaque chimique aura pour effet de créer des canaux de diffusion allant d'une surface à l'autre de ladite matrice. Ces nanofils d'oxyde de silicium présentent, de préférence, un diamètre allant de quelques nm à quelques dizaine de nm et, mieux encore, de 2 nm à 10 nm.

Des nanofils d'oxyde de silicium peuvent être formés par de nombreuses techniques et, notamment, par dépôt chimique en phase vapeur (ou CVD), décomposition thermique catalytique, également connue sous le sigle CCVD pour « **C**atalytic **C**hemical **V**apor **D**eposition », ou encore par la voie sol-gel.

Toutefois, dans le cadre de l'invention, on préfère réaliser ces nanofils par la voie sol-gel. On forme ensuite, autour des nanofils ainsi obtenus, la matrice, de préférence par PECVD. En effet, de par le fait que cette technique autorise la réalisation de dépôts à de basses pressions, elle permet de recouvrir ces nanofils, sur toute leur longueur, avec le ou les matériaux constitutifs de la matrice, étant entendu que l'on veillera à régler la durée du dépôt de sorte que les extrémités des nanofils ne soient pas incluses dans la matrice et puissent rester ainsi accessibles à l'agent d'attaque chimique.

En variante, l'oxyde de silicium peut également être présent dans la matrice sous la forme d'inclusions, en utilisant par exemple une approche porogène par PECVD ou dépôt par centrifugation, encore connu sous la terminologie anglaise « spin coating ».

Quel que soit le mode de mise en oeuvre du procédé de l'invention, on préfère que la membrane imperméable présente une épaisseur allant de 10 nm à 10 µm et, mieux encore, de 100 nm à 1 µm.

Par ailleurs, on préfère que le matériau sacrificiel soit de l'oxyde de silicium et que l'agent d'attaque chimique soit un fluide contenant de l'acide fluorhydrique.

Conformément à l'invention, ce fluide est, de préférence, une solution aqueuse ou organique à 1 ou quelques % (v/v) d'acide fluorhydrique, auquel cas l'étape b) peut être réalisée par simple trempage de la microstructure dans cette solution.

Toutefois, il peut également s'agir d'acide fluorhydrique gazeux, pur ou mélangé à un gaz porteur tel que l'azote, ou d'un mélange d'acide fluorhydrique et de dioxyde de carbone supercritique, par exemple dans un rapport de 1/100 (v/v).

Quant à l'étape c), elle peut être réalisée de façon conventionnelle, c'est-à-dire par immersion dans de l'eau désionisée suivie d'un séchage, par exemple à 100°C pendant 30 minutes.

Le procédé de l'invention présente de nombreux avantages, en particulier celui de résoudre tous les problèmes posés par l'intégration de membranes perméables, précédemment évoqués.

D'autres caractéristiques et avantages de l'invention apparaîtront mieux à la lecture du complément de description qui suit et qui se rapporte à des exemples de mise en oeuvre du procédé de l'invention.

Bien entendu, ces exemples ne sont donnés qu'à titre d'illustrations de l'objet de l'invention et ne constituent en aucun cas une limitation de cet objet.

### BRÈVE DESCRIPTION DES DESSINS

Les figures 1A et 1B, déjà commentées, illustrent de façon schématique un procédé de réalisation de cavités d'air selon l'art antérieur, dans le cas d'une structure d'interconnexions pour circuit intégré.

Les figures 2A et 2B illustrent de façon schématique un premier exemple de mise en oeuvre du procédé de réalisation de cavités d'air selon l'invention, dans le cas d'une structure d'interconnexions pour circuit intégré.

Les figures 3A et 3B illustrent de façon schématique un deuxième exemple de mise en oeuvre du procédé de réalisation de cavités d'air selon l'invention, dans le cas d'une structure d'interconnexions pour circuit intégré.

Pour des raisons de clarté, les dimensions des différents constituants des structures représentées sur ces figures ne sont pas en proportion avec leurs dimensions réelles.

### EXPOSÉ DÉTAILLÉ DE MODES DE MISE EN OEUVRE PARTICULIERS

### Exemple 1 :

On se réfère tout d'abord aux figures 2A et 2B qui illustrent sous une forme schématique un premier exemple de mise en oeuvre du procédé de l'invention pour la réalisation de cavités d'air dans une structure d'interconnexions pour circuit intégré.

Dans cet exemple, le matériau sacrificiel est de l'oxyde de silicium tandis que la membrane imperméable est une membrane de SiᵥC_{w}NₓH_{y}O_{z} (avec v, w, x, y et z tous différents de 0) qui présente une teneur en oxygène de l'ordre de 10% atomique et une épaisseur de 200 nm.

On réalise tout d'abord la structure montrée sur la figure 2A qui comprend des cavités 25 remplies de SiO₂.

Pour ce faire, on réalise, sur un substrat semiconducteur adapté, typiquement en silicium, un premier niveau d'interconnexions comprenant des lignes métalliques 22a et 22b, typiquement en cuivre, noyées dans une première couche 21 de SiO₂. Ce premier niveau d'interconnexions peut être réalisé selon une route classique, c'est-à-dire par exemple par :
■ dépôt d'une couche 21 de SiO₂ sur le substrat,
■ définition d'un motif d'interconnexions sur la couche 21 de SiO₂ par un procédé de lithographie utilisant un masque dur,
■ gravure de la couche 21 de SiO₂ au travers du masque jusqu'à révéler le substrat 20, puis
■ formation des lignes métalliques 22a et 22b dans le motif de gravure.

On dépose ensuite, sur ce premier niveau d'interconnexions, une membrane imperméable 23, par PECVD à partir de tétraméthylsilane, d'oxygène, d'ammoniac et d'hélium, par exemple dans l'une des chambres de dépôt PECVD à couplage capacitif d'une Centura^{®} DxZ 200 mm de la société Applied Materials, et en utilisant les paramètres opératoires suivants :
Excitation radiofréquence : 13,56 MHz
Pression de travail : 3 torrs (0,4 kPa)
Puissance : 310 W
Température de dépôt : 350°C
Flux de tétraméthylsilane : 80 cm³/min
Flux d'oxygène : 10 cm³/min
Flux d'ammoniac : 160 cm³/min
Flux d'hélium : 200 cm³/min
Durée du dépôt : 1 minute.

A l'issue de ce dépôt, on réalise sur la membrane 23, là également selon une route classique, un deuxième niveau d'interconnexions comprenant des lignes métalliques 22c et 22d noyées dans une deuxième couche 21' de SiO₂, ces lignes étant connectées respectivement aux lignes métalliques 22a et 22b par l'intermédiaire de traverses 24.

On peut bien entendu réaliser sur le même principe d'autres niveaux d'interconnexions, séparés à chaque fois du niveau d'interconnexions précédent par une membrane imperméable identique à la membrane 23.

Puis, on plonge la structure dans une solution aqueuse à 1% (v/v) d'acide fluorhydrique pendant 20 minutes, ce qui a pour effet de dégrader la couche 21' de SiO₂ du deuxième niveau d'interconnexions, de rendre la membrane 23 perméable par destruction sélective des liaisons Si-O qu'elle renferme, puis de dégrader la couche 21 de SiO₂ du premier niveau d'interconnexions. Le temps de traitement à l'acide fluorhydrique est déterminé en fonction de l'épaisseur de la couche 21 (environ 1 minute pour 10 nm) et en comptant 5 minutes de traitement pour la dégradation des liaisons Si-O de la membrane 23.

Après avoir retiré la structure de la solution d'acide fluorhydrique, on la plonge dans de l'eau désionisée puis on la sèche à 100°C pendant 30 minutes.

On obtient ainsi la structure illustrée sur la figure 2B dans laquelle les cavités 25 sont remplies d'air.

### Exemple 2 :

On se réfère à présent aux figures 3A et 3B qui illustrent sous une forme schématique un deuxième exemple de mise en oeuvre du procédé de l'invention pour la réalisation de cavités d'air dans une structure d'interconnexions pour circuit intégré, qui ne diffère de celui décrit dans l'exemple 1 que par la nature de la membrane imperméable qui est intégrée dans la structure.

En effet, dans le présent exemple, la membrane imperméable 33 est constituée d'une matrice de carbure de silicium hydrogéné amorphe (a-SiC:H), de 200 nm d'épaisseur et dans laquelle sont dispersés des nanofils traversants de SiO₂.

Pour obtenir cette membrane, on forme tout d'abord, sur le premier niveau d'interconnexions de la structure, les nanofils de SiO₂.

Pour ce faire, on prépare une première solution en ajoutant graduellement 52 ml de tétraéthyl-orthosilicate (TEOS) à 115 mL d'éthanol et une deuxième solution en mélangeant 115 mL d'éthanol à 18 mL d'eau et 0,27 mL d'acide chlorhydrique. La deuxième solution est ensuite ajoutée à la première. Le mélange résultant est étalé par centrifugation sur le premier niveau d'interconnexions et la structure est placée dans une enceinte chauffée (200°C) pendant 12 heures.

On forme ensuite, autour des nanofils de SiO₂ ainsi obtenus, la matrice de SiᵥC_{w}H_{y} par PECVD à partir de triméthylsilane et d'hélium, par exemple dans un réacteur à couplage capacitif du type Centura^{®} 5200 DxZ de la société Applied Materials, et en utilisant les paramètres opératoires suivants :
Excitation radiofréquence : 13,56 MHz
Pression de travail : 4 torrs (533 Pa)
Puissance : 250 W
Température de dépôt : 350-400°C
Flux de triméthylsilane : 350 cm³/min
Flux d'hélium : 4900 cm³/min
Durée du dépôt : 8 minutes.

On soumet alors la membrane ainsi formée à un polissage mécano-chimique pendant 10 secondes, au moyen d'une suspension aqueuse basique (pH 8) de particules colloïdales de silice et en utilisant une vitesse de rotation du plateau de 80 tours/min et une pression de 2 psi (13,789 kPa).

Comme dans l'exemple 1, pour remplacer les cavités 35 remplies de SiO₂ de la structure montrée sur la figure 3A par des cavités d'air (figure 3B), il suffit :
- de plonger la structure dans une solution aqueuse à 1% (v/v) d'acide fluorhydrique pendant 20 minutes, ce qui a pour effet de dégrader la couche 31' de SiO₂ du deuxième niveau d'interconnexions, de rendre la membrane 33 perméable par dégradation sélective des nanofils de SiO₂ et création de canaux de diffusion traversants (référencés 36 sur la figure 3B), et enfin de dégrader la couche 31 de SiO₂ du premier niveau d'interconnexions, puis
- de retirer la structure de la solution d'acide fluorhydrique, de la plonger dans de l'eau désionisée puis de la sécher à 100°C pendant 30 minutes.

## Revendications

1. Procédé de réalisation d'au moins une cavité d'air (25, 35) dans une microstructure, du type comprenant la dégradation d'un matériau sacrificiel par diffusion d'un agent d'attaque chimique au travers d'une membrane, qui comprend :
a) la fourniture d'une microstructure comprenant au moins une cavité (25, 35) remplie d'un matériau sacrificiel, cette cavité étant limitée sur au moins une partie de sa surface par une membrane imperméable (23, 33) mais qui peut être rendue perméable sous l'action d'un agent d'attaque chimique, cet agent étant également capable de dégrader le matériau sacrificiel ;
b) la mise en contact de la microstructure avec ledit agent d'attaque chimique pour rendre la membrane perméable et dégrader le matériau sacrificiel ; et
c) l'élimination de l'agent d'attaque chimique de la microstructure, moyennant quoi on obtient une cavité d'air ; et
dans lequel l'agent d'attaque chimique est un fluide contenant de l'acide fluorhydrique et/ou du fluorure d'ammonium.

2. Procédé selon la revendication 1, dans lequel la membrane imperméable est constituée d'un seul matériau.

3. Procédé selon la revendication 2, dans lequel le matériau comprend du silicium, du carbone, de l'hydrogène, de l'oxygène et, éventuellement, de l'azote et/ou du fluor, une majorité de liaisons silicium-carbone et une proportion de liaisons silicium-oxygène telle que l'oxygène présent dans ledit matériau représente au plus 30% en nombre d'atomes.

4. Procédé selon la revendication 3, dans lequel le matériau est de type SiᵥC_{w}H_{y}O_{z} ou SiᵥC_{w}NₓH_{y}O_{z} avec v, w, x, y et z tous différents de 0.

5. Procédé selon la revendication 3 ou la revendication 4, dans lequel la membrane imperméable est formée par dépôt chimique en phase vapeur assisté par plasma.

6. Procédé selon la revendication 5, dans laquelle la membrane imperméable étant de type SiᵥC_{w}H_{y}O_{z}, elle est formée en utilisant un plasma contenant un premier précurseur organosilicié exempt d'oxygène et un deuxième précurseur constitué d'oxygène, seul ou en combinaison avec du carbone et/ou de l'hydrogène.

7. Procédé selon la revendication 6, dans lequel le premier précurseur est un alkylsilane tandis que le deuxième précurseur est de l'oxygène ou du dioxyde de carbone.

8. Procédé selon la revendication 5, dans lequel la membrane étant de type SiᵥC_{w}NₓH_{y}O_{z}, elle est formée en utilisant un plasma contenant un premier précurseur organosilicié exempt d'oxygène, un deuxième précurseur constitué d'oxygène, seul ou en combinaison avec du carbone et/ou de l'hydrogène et un troisième précurseur constitué d'azote, seul ou en combinaison avec de l'hydrogène et/ou du carbone.

9. Procédé selon la revendication 8, dans lequel le premier précurseur est un alkylsilane, le deuxième précurseur est de l'oxygène ou du dioxyde de carbone tandis que le troisième précurseur est de l'azote ou de l'ammoniac.

10. Procédé selon la revendication 1, dans lequel la membrane imperméable est constituée d'au moins un premier matériau résistant à l'agent d'attaque chimique et dans laquelle est dispersé au moins un deuxième matériau dégradable par ledit agent d'attaque chimique.

11. Procédé selon la revendication 10, dans lequel le premier matériau comprend du silicium, du carbone, de l'hydrogène et, éventuellement, de l'azote et/ou du fluor, mais est exempt d'oxygène.

12. Procédé selon la revendication 11, dans lequel le premier matériau est de type SiᵥC_{w}H_{y} avec v, w et y tous différents de 0.

13. Procédé selon l'une quelconque des revendications 10 à 11, dans lequel le deuxième matériau est de l'oxyde de silicium.

14. Procédé selon la revendication 13, dans lequel l'oxyde de silicium est présent dans la matrice sous la forme de nanofils traversants.

15. Procédé selon la revendication 14, dans lequel les nanofils d'oxyde de silicium sont formés par la voie sol-gel.

16. Procédé selon la revendication 13, dans lequel l'oxyde de silicium est présent dans la matrice sous forme d'inclusions.

17. Procédé selon l'une quelconque des revendications précédentes, dans lequel le matériau sacrificiel est de l'oxyde de silicium.

18. Procédé selon l'une quelconque des revendications précédentes, dans lequel l'agent d'attaque chimique est un fluide contenant de l'acide fluorhydrique.

19. Procédé selon la revendication 18, dans lequel le fluide contenant de l'acide fluorhydrique est une solution aqueuse ou organique d'acide fluorhydrique, de l'acide fluorhydrique gazeux, un mélange d'acide fluorhydrique gazeux et d'un gaz porteur ou bien un mélange d'acide fluorhydrique et de dioxyde de carbone supercritique.

20. Procédé selon l'une quelconque des revendications précédentes, dans lequel la microstructure est une structure d'interconnexions pour circuit intégré.

## Claims

1. Process for producing at least one air gap (25, 35) in a microstructure, of the type comprising the degradation of a sacrificial material by diffusion of a chemical etchant through a membrane, which comprises:
a) the supply of a microstructure comprising at least one gap (25, 35) filled with a sacrificial material, this gap being limited over at least part of its surface by an impermeable membrane (23, 33) but which may be rendered permeable by the action of a chemical etchant, this etchant also being capable of degrading the sacrificial material;
b) the contacting of the microstructure with said chemical etchant in order to make the membrane permeable and degrade the sacrificial material; and
c) the removal of the chemical etchant from the microstructure, whereby an air gap is obtained;
and in which the chemical etchant is a fluid containing hydrofluoric acid and/or ammonium fluoride.

2. Process according to Claim 1, in which the impermeable membrane consists of a single material.

3. Process according to Claim 2, in which the material comprises silicon, carbon, hydrogen, oxygen and, possibly, nitrogen and/or fluorine, a majority of silicon-carbon bonds and a proportion of silicon-oxygen bonds such that the oxygen present in said material represents at most 30% of the atoms by number.

4. Process according to Claim 3, in which the material is of the SiᵥC_{w}H_{y}O_{z} or SiᵥC_{w}NₓH_{y}O_{z} type where v, w, x, y and z are all different from 0.

5. Process according to Claim 3 or Claim 4, in which the impermeable membrane is formed by plasma-enhanced chemical vapour deposition.

6. Process according to Claim 5, in which the impermeable membrane is of the SiᵥC_{w}H_{y}O_{z} type and is formed using a plasma containing an organosilicon first precursor containing no oxygen and a second precursor consisting of oxygen, alone or in combination with carbon and/or hydrogen.

7. Process according to Claim 6, in which the first precursor is an alkylsilane while the second precursor is oxygen or carbon dioxide.

8. Process according to Claim 5, in which the membrane is of the SiᵥC_{w}NₓH_{y}O_{z} type and is formed using a plasma containing an organosilicon first precursor containing no oxygen, a second precursor consisting of oxygen, alone or in combination with carbon and/or hydrogen, and a third precursor consisting of nitrogen, alone or in combination with hydrogen and/or carbon.

9. Process according to Claim 8, in which the first precursor is an alkylsilane, the second precursor is oxygen or carbon dioxide while the third precursor is nitrogen or ammonia.

10. Process according to Claim 1, in which the impermeable membrane consists of at least a first material resistant to the chemical etchant and in which at least a second material degradable by said chemical etchant is dispersed.

11. Process according to Claim 10, in which the first material comprises silicon, carbon, hydrogen and, possibly, nitrogen and/or fluorine, but contains no oxygen.

12. Process according to Claim 11, in which the first material is of the SiᵥC_{w}H_{y} type where v, w and y are all different from 0.

13. Process according to either of Claims 10 and 11, in which the second material is silicon oxide.

14. Process according to Claim 13, in which the silicon oxide present in the matrix is in the form of through-nanowires.

15. Process according to Claim 14, in which the silicon oxide nanowires are formed by the sol-gel route.

16. Process according to Claim 13, in which the silicon oxide present in the matrix is in the form of inclusions.

17. Process according to any one of the preceding claims, in which the sacrificial material is silicon oxide.

18. Process according to any one of the preceding claims, in which the chemical etchant is a fluid containing hydrofluoric acid.

19. Process according to Claim 18, in which the fluid containing hydrofluoric acid is an aqueous or organic hydrofluoric acid solution, gaseous hydrofluoric acid, a mixture of gaseous hydrofluoric acid and a carrier gas, or a mixture of hydrofluoric acid and supercritical carbon dioxide.

20. Process according to any one of the preceding claims, in which the microstructure is an interconnect structure for integrated circuits.

## Patentansprüche

1. Herstellungsverfahren wenigstens eines Lufthohlraums (25, 35) in einer Mikrostruktur, von dem Typ, der den Abbau eines Opfermaterials durch Diffusion eines chemischen Ätzmittels durch eine Membran hindurch aufweist, und das umfasst:
a) die Zulieferung einer Mikrostruktur mit wenigstens einem Hohlraum (25, 35), gefüllt mit wenigstens einem Opfermaterial, wobei dieser Hohlraum auf wenigstens einem Teil seiner Oberfläche abgegrenzt ist durch eine undurchlässige Membran (23, 33), die aber durchlässig gemacht werden kann durch die Winkung eines chemischen Ätzmittels, wobei dieses Ätzmittel ebenfalls fähig ist, das Opfermaterial abzubauen;
b) die Kontaktherstellung der Mikrostruktur mit dem genannten chemischen Ätzmittel; und
c) die Beseitigung des chemischen Ätzmittels aus der Mikrostruktur, so dass man einen Lufthohlraum erhält;
und bei dem das chemische Ätzmittel ein Fluid ist, das Flußsäure und/oder Ammoniumfluorid enthält.

2. Verfahren nach Anspruch 1, bei dem die undurchlässige Membran durch ein einziges Material gebildet wird.

3. Verfahren nach Anspruch 2, bei dem das Material umfasst: Silicium, Kohlenstoff, Wasserstoff, Sauerstoff und eventuell Stickstoff und/oder Fluor, eine Mehrheit Silicium-Kohlenstoff-Verbindungen und einen Anteil Silicium-Sauerstoff-Verbindungen, so dass der in dem genannten Material vorhandene Sauerstoff höchstens 30% in Anzahl Atome darstellt.

4. Verfahren nach Anspruch 3, bei dem das Material vom Typ SiᵥC_{w}H_{y}O₂ oder SiᵥC_{w} NₓH_{y}O_{z} ist, mit v, w, x, y und z alle ungleich 0.

5. Verfahren nach Anspruch 3 oder Anspruch 4, bei dem die undurchlässige Membran durch plasmaunterstützte chemische Gasphasenabscheidung erzeugt wird.

6. Verfahren nach Anspruch 5, bei dem die undurchlässige Membran vom Typ SiᵥC_{w}H_{y}O_{z} ist und gebildet wird, indem man ein Plasma benutzt, das einen ersten Organosilicium-Vorläufer ohne Sauerstoff und einen zweiten Vorläufer, gebildet durch Sauerstoff, allein oder in Kombination mit Kohlenstoff und/oder Wasserstoff, umfasst.

7. Verfahren nach Anspruch 6, bei dem der erste Vorläufer ein Alkylsilan ist, während der zweite Vorläufer Sauerstoff oder Kohlendioxid ist.

8. Verfahren nach Anspruch 5, bei dem die Membran vom Typ SiᵥC_{w}NₓH_{y}O_{z} ist und gebildet wird, indem man ein Plasma benutzt, das umfasst: einen ersten Organosilicium-Vorläufer ohne Sauerstoff, einen zweiten Vorläufer, gebildet durch Sauerstoff, allein oder in Kombination mit Kohlenstoff und/oder Wasserstoff, und einen dritten Vorläufer, gebildet durch Stickstoff, allein oder in Kombination mit Wasserstoff und/oder Kohlenstoff.

9. Verfahren nach Anspruch 8, bei dem der erste Vorläufer ein Alkylsilan ist, der zweite Vorläufer Sauerstoff oder Kohlendioxid ist, während der dritte Vorläufer Stickstoff oder Ammoniak ist.

10. Verfahren nach Anspruch 1, bei dem die undurchlässige Membran durch wenigstens ein erstes, gegenüber dem chemischen Ätzmittel resistentes Material gebildet wird, in dem wenigstens ein zweites, durch das genannte chemische Ätzmittel abbaubares Material dispergiert ist.

11. Verfahren nach Anspruch 10, bei dem das erste Material Silicium, Kohlenstoff, Wasserstoff und eventuell Stickstoff und/oder Fluor enthält, aber keinen Sauerstoff.

12. Verfahren nach Anspruch 11, bei dem das erste Material vom Typ SiᵥC_{w}H_{y} ist, mit v, w und y alle ungleich 0.

13. Verfahren nach einem der Ansprüche 10 bis 11, bei dem das zweite Material Siliciumoxid ist.

14. Verfahren nach Anspruch 13, bei dem das Siliciumoxid in der Matrix in Form von Durchgangs-Nanofasern präsent ist.

15. Verfahren nach Anspruch 14, bei dem die Siliciumoxid-Nanofasern auf dem Sol-Gel-Verfahrensweg gebildet werden.

16. Verfahren nach Anspruch 13, bei dem das Siliciumoxid in der Matrix in Form von Einschlüssen präsent ist.

17. Verfahren nach einem der vorhergehenden Ansprüche, bei dem das Opfermaterial Siliciumoxid ist.

18. Verfahren nach einem der vorhergehenden Ansprüche, bei dem das chemische Ätzmittel ein Flußsäure enthaltende Fluid ist.

19. Verfahren nach Anspruch 18, bei dem das Flußsäure enthaltende Fluid eine wässerige oder organische Flußsäurelösung, gasförmige Flußsäure, eine Mischung aus gasförmiger Flußsäure und einem Trägergas oder auch eine Mischung aus Flußsäure und überkritische Kohlendioxid ist.

20. Verfahren nach einem der vorhergehenden Ansprüche, bei dem die Mikrostruktur eine Zusammenschaltungsstruktur für Integrierte Schaltung ist.
